# EUROPEAN PATENT SPECIFICATION

(11) **EP 2 902 987 B1**
(45) Date of publication and mention of the grant of the patent: **27.07.2016**
(21) Application number: 14382028.0
(22) Date of filing: 30.01.2014
(51) Int. Cl.: G08G 5/00

(54) **Method for modeling aircraft performance through adaptive aircraft performance models**
Verfahren zur Modellierung von Flugzeugleistung durch adaptive Flugzeugmodellleistung
Procédé permettant de modéliser les performances d'un aéronef par le biais de modèles adaptatifs de performances d'aéronef

(43) Date of publication of application: 05.08.2015
(73) Proprietor: The Boeing Company, Chicago, IL 60606-1596 (US)
(72) Inventor: Casado, Enrique, 28042 Madrid (ES)
(74) Representative: Ungria López, Javier

(56) References cited:
- US-A1- 2008 234 994
- US-A1- 2012 116 614
- US-A1- 2014 005 861
- VILAPLANA M A ET AL: "Towards a Formal Language for the Common Description of Aircraft Intent", DIGITAL AVIONICS SYSTEMS CONFERENCE, 2005. DASC 2005. THE 24TH WASHINGTON, DC, USA 30 OCTOBER - 03 NOVEMBER 2005, IEEE, PISCATAWAY, NJ, USA, vol. 1, 30 October 2005 (2005-10-30), pages 3.C.5-1, XP010868246, ISBN: 978-0-7803-9307-3
- Steve Barker: "Aircraft performance monitoring", , 1 April 2013 (2013-04-01), pages 1-30, XP055126057, Retrieved from the Internet: URL:http://www.caac.gov.cn/dev/fbs/xjsyy/2 01305/P020130503515529640340.pdf [retrieved on 2014-06-30]
- ANGELA NUIC ET AL: "BADA: An advanced aircraft performance model for present and future ATM systems", INTERNATIONAL JOURNAL OF ADAPTIVE CONTROL AND SIGNAL PROCESSING, vol. 24, no. 10, 19 October 2010 (2010-10-19), pages 850-866, XP055126167, ISSN: 0890-6327, DOI: 10.1002/acs.1176

## Description

### FIELD OF THE INVENTION

The present invention proposes a computer implemented method to improve the fidelity of aircraft performance models (APMs) used by aircraft trajectory predictors and air traffic simulators in Air Traffic Management (ATM). The method is based on the use of recorded flight data to identify statistically significant deviations between the actual performances of an aircraft in operational flight and the nominal performance values provided by the nominal APM for that aircraft type.

### BACKGROUND OF THE INVENTION

Advanced trajectory modeling and traffic simulation capabilities require from high fidelity APMs that usually are generic representations of the nominal aircraft performances. A main need both in the current and future ATM paradigms is to have highly accurate aircraft trajectory predictions computed on-ground. The widely accepted models used by the ATM community are the Eurocontrol BADA (Base of Aircraft Data) models [http://www.eurocontrol.int/services/bada]. Among others, BADA enables aircraft trajectory modeling in support of the following applications:
- Air traffic simulation for operations analysis and Air Traffic Control (ATC) training.
- Research and validation of new ATM concepts, tools and equipment before they are introduced into operational service.
- Trajectory prediction for ground-based ATM systems (e.g. Flight Data Processing Systems).
- Environmental assessment of air traffic operations, e.g. impact of noise and emissions.

BADA is made up of two main components: the model specification and the datasets. The model specification consists of a set of polynomial expressions used to calculate aircraft performance parameters such as the drag coefficient, fuel consumption, engine thrust, etc. The polynomials are parameterized by a set of coefficients that particularize the polynomial expressions for specific aircraft types. These coefficients are the BADA datasets. Each aircraft type (airframe-engine combination) has associated a specific BADA dataset. The BADA dataset of an aircraft type used in conjunction with the BADA model specification provide approximate values of the aircraft performance characteristics (drag polar, thrust coefficient, fuel consumption, etc) of that aircraft.

However, these models lack in information about aircraft performances degradation, and therefore, they should be considered as generic representations of the average nominal aircraft performances of the aircraft based on manufacturers' information. Hence, potential improvements of the aircraft performance models are possible if data from real operations are available to the ground-based infrastructure. Taking advantage of the BADA model specifications, it would be possible to improve the datasets by updating them thanks to the use of operational data of aircraft of the same type operating in a given environment by applying the proposed methodology.

The most accurate and up-to-date information about real aircraft performances is only available onboard. The Flight Management System (FMS) makes use of this information when commanding and controlling the aircraft. However, this information is not known by the Decision Support Tools (DST) supporting the standard operations. This information can only be accessed off-board by the airlines during the maintenance procedures (download of recorded flight data and health monitoring information).

Nowadays, there are no alternatives rather than using generic nominal APMs, such as BADA models, for representing the performances of the whole fleet of same-type aircraft. Those models have been widely accepted by the ATM community as the best representation of the performances of the majority of commercial aircrafts.

Further to the degradation suffered by the aircraft, document "Aircraft Performance Degradation" (M. Foueri 16th Performance and Operations Conference, May 2009) describes the influence of the engine degradation and the aerodynamic degradation over the optimal operational values of the aircraft performance. The degradation of aircraft performance admissible by the users is of course not unlimited. An example of how engine and aerodynamic degradation increase the fuel consumption and therefore decrease the efficiency of an aircraft is disclosed in document "Guidance Material and Best Practices for Fuel and Environmental Management" (International Air Transport Association (IATA), 3rd Edition, 2008). Airlines establish a detailed maintenance program for each individual aircraft in order to maintain its performance as closest as possible to the optimal operational values. When performance decreases below certain threshold, the maintenance procedures define how to proceed for recovering the optimal behavior. For example, for every 3.000 hours of flight time or 1.000 cycles, new airplanes lose about 1% of efficiency and after a few years of operation, the fuel burn tend to stabilize at 5% to 7% above the new aircraft performance levels. The extra fuel consumption can be therefore imputed to an increase of drag values and a decrease of thrust provided by the engine at same regimes, although more sophisticated approaches could also be valid.

Document US2014/005861 describes a method and a device for assisting the mission tracking of an aircraft. It tracks the evolution of the parameters of the aircraft so as to compute deviations of the flight parameter with respect to a reference flight plan.

Document US2008/0234994 describes a system and a method for multi-objective deterioration accommodation using a simulated machine that simulates a deteriorated actual machine and s simulated controller that simulates an actual controller.

Document US2012/0116614 discloses an apparatus and a method to synchronize the distinct trajectories predicted by a flight management system and air navigation service provider by generating synchronized trajectories that resolve identified discrepancies and restriction violations between trajectories.

### SUMMARY OF THE INVENTION

Although the enhanced aircraft performance models will improve the predictability of advanced automation tools required for supporting the Trajectory Based Operations (TBO) concept upon which the future ATM system will rely on, it is possible to obtain short-term predictability improvements applying this method to the models used by current prediction and traffic simulation infrastructures.

The object of the present invention is a computer implemented method for modeling aircraft performance through adaptive aircraft performance models using actual flight recorded data. The mentioned data at least should comprise information about the aircraft state variables throughout the flight, data of the weather faced during flight by the aircraft and aircraft configuration data. Other information (aircraft intent) related to how the aircraft has been operated, i.e. the command and control instructions issued by the pilot or the FMS can also be very useful for the process.
The method at least comprises the following stages:
a) identifying coefficients in a nominal polynomial aircraft performance model of the aircraft which will be modeled in order to represent the degradation in performance. Thus, the degraded APM will be a polynomial description of the aircraft performances including the degradation effects described by the APDM (Aircraft Performance Degradation Model). The APDM is a selection criteria used for perturbing the elements of the APM which will represent the degradation in performance in accordance with the established hypothesis. The hypotheses provided by the APDM are translated to trajectory Computation Infrastructure which is a computational infrastructure required for calculating an aircraft trajectory based on the set of required inputs (Aircraft Intent, Weather Model, Initial Conditions and APM). The threshold could be established by considering the model which would result in a minor average error in the measure of the mass of an aircraft during the complete trajectory of said aircraft, or any other similar criteria; and,
e) modifying, when the result of the comparison between the computed trajectory data and the recorded trajectory data is higher than the previously established threshold, the aircraft degradation coefficients. Once the coefficients have been modified, stages a) to e) of the method have to be executed until the result of the comparison is less than the previously established threshold.

In a particular embodiment of the invention, the aircraft degradation coefficients are modeled by worsening the coefficients which instantiate the polynomial description of the aircraft performance. The main reasons for appearing performance degradation in an aircraft are twofold: airframe deterioration due to deformed aerodynamic surfaces, seals missing or damaged, chipped paint or doors not flush or leaking; and engine ageing due to fan blade leading edge erosion, blended blades or nacelle air leakage. The influence of the engine degradation is much higher (80% approximately) than the influence of the aerodynamic degradation (20% approximately) above the optimal operational values of the aircraft performance. It reflects that engine behavior is the key element for maintaining the performances within the optimal operational values. The APDM relates the extra fuel consumption with the polynomial description of the drag polar curve and the engine thrust curve. This is a model which represents how the performance degrades with time and operations.

In another embodiment of the present invention, the aircraft degradation coefficients which instantiate the polynomial description of the aircraft performance are coefficients of drag polar, engine thrust and fuel consumption of the aircraft.

In another embodiment of the present invention, when the aircraft performance data do not comprise information related with the aircraft intent, the aircraft intent and the aircraft configuration are obtained by means of aircraft intent inference techniques which use as inputs the weather data, the recorded trajectory data of the aircraft and the nominal aircraft performance model. These aircraft intent inference techniques are carried out by an engine which is an infrastructure capable of deducting the aircraft intent which corresponds to the flown trajectory by means of inferring it from the recorded flight data. This model basically provides the altitude and speed laws which describe the vertical profile of the trajectory, and a function of the geographic latitude and longitude for determining the lateral profile.

In another embodiment of the invention, the comparing stage between the computed trajectory data and the recorded trajectory data is carried out by comparing target state variables between the recorded trajectory data and the computed trajectory data. In a more preferred embodiment the target state variables are selected among fuel consumption and net thrust.

Once an enhanced APM is obtained, it can be used by any trajectory computation infrastructure. The enhanced APM is an improved polynomial description of the aircraft performance which provides an improved model of such performance.

The main advantage of the method herein disclosed will be the enhancement of prediction capabilities of aircraft trajectories on-ground (onboard the FMS manages the most up-to-date information about aircraft performances, and therefore, computes the most accurate predications). Any ATM stakeholder who require from accurate aircraft trajectory predictions would obtain benefits from its use:
- Air Navigation Service Providers. They require prediction for managing efficient and safely the air traffic. Besides, they have available radar track information and Automatic Dependent Surveillance - Broadcast (ADS-B) information which can be exploited to obtain precise models of real aircraft. The method object of the present invention could be implemented for generating general models for aircraft of the same type, for the same type and same airline, and even for the same aircraft because the aircraft identificator (ID) can be matched with its performance. This would deliver an increase of current prediction capabilities.
- Airlines. They use trajectory prediction for optimizing their operations, managing efficiently the whole fleet and planning future operations. This will provide a fast procedure for using a realistic representation of the performances of every individual aircraft while monitoring the degradation in performances. The present invention cannot replace the current maintenance procedures but can be seen as a useful mechanism for tracking this behavior.
- ATM stakeholders in general. Due to no other related models are available, the method object of the present invention would enable the capability of introducing the degradation of aircraft performances in any of the tools developed by the stakeholder whose goal is providing reliable hints and suggestions to third parties (i.e., Arrival Managers, Departure Managers, Conflict Detection & Resolution tools...)

The method herein disclosed represents the first approach to the problem of modeling the degradation of the aircraft performances to be included in generic polynomial descriptions of such performances. The current systems belonging to the state of the art are not able to generate highly accurate APMs.

The methodology can be applied to airport procedures design, improving the process of validation thanks to accurate tailoring the analysis to the aircraft types and specific airlines to operate in the considered airport.

### BRIEF DESCRIPTION OF THE FIGURES

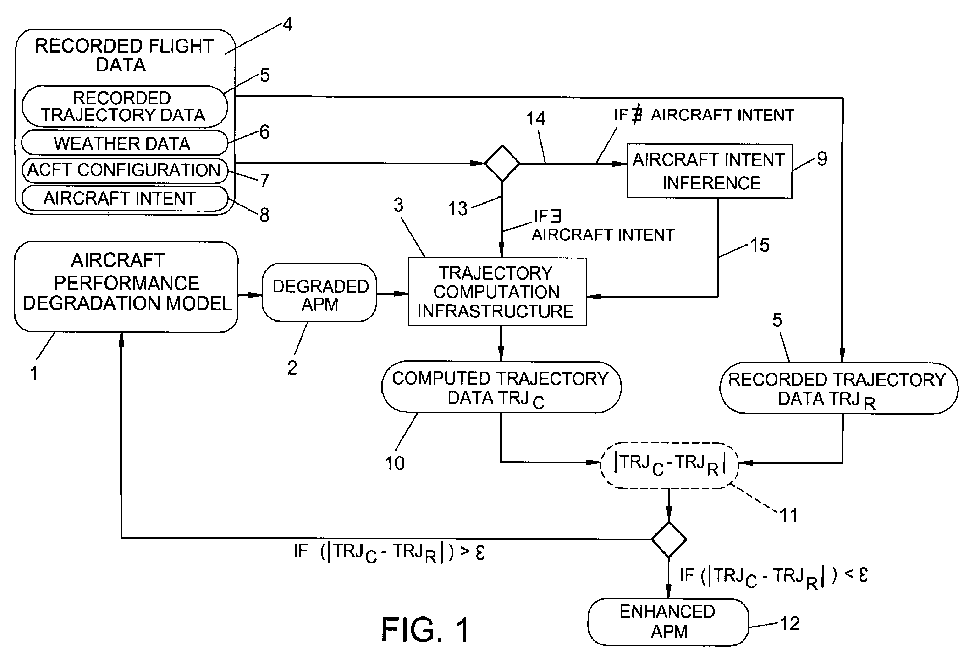

Figure 1.- It shows a flow diagram that describes the method object of the present invention. This method provides a more realistic APM based on theoretical assumptions about performances degradation and on the use of recorded flight data.

### DESCRIPTION OF AN EXAMPLE OF EMBODIMENT OF THE INVENTION

An example of a particular embodiment of the method object of the present invention is herein disclosed making reference to the figures.

Starting from an Aircraft Performance Degradation Model (1)(APDM) hypothesis related to the degradation of aircraft performances, a degraded APM (2) is generated. This APDM (1) is a nominal aircraft performance model in which the engine performance and airframe performance models have been identified. The APDM (1) comprises a polynomial description of the airframe degradation of the aircraft and the polynomial description of engine degradation and basically identifies the coefficients of the polynomial descriptions of the drag polar and the engine net thrust models that can represent the performance degradation of the aircraft. The nominal values of such coefficients are replaced by values that approximate such degradation in the nominal APM of the aircraft. With the new polynomial description of the aircraft performance provided by the APDM (1), a degraded APM is generated (2).

The recorded flight data (4) are private information by the airlines or they are public information usually provided by the Air Traffic Control (ATC). This public information is mainly Automatic Dependent Surveillance-Broadcast information (ADSB). When the recorded flight data (4) is provided by the airlines, this information has been previously recorded by the Flight Data Recorder System (FDRS) onboard and subsequently downloaded when the aircraft is on ground.

If the recorded flight data (4) come from the airlines and then they have been provided by the Flight Data Recorder System (FDRS) onboard, said recorded flight data (4) comprise recorded trajectory data (4D trajectory) (5), actual weather data (6) faced by the aircraft during flight aircraft configuration (7), information about the aircraft intent (8). Then the computation process is straightforward and said recorded flight data (4) are sent (13) to the trajectory computation infrastructure (3) for calculating the computed trajectory data (10).

If the recorded flight data (4) has been provided by Automated Dependent Surveillance - Broadcast (ADS-B) infrastructure, they do not comprise information about the aircraft intent (8) or information of the aircraft configuration (7). Then a process for inferring the aircraft intent (8) and the aircraft configuration (7) needs to be executed. This process provides the aircraft intent (8) and an aircraft configuration (7) by sending (14) the recorded trajectory data (5) provided by the ADS-B and a numerical prevision weather model to an aircraft intent inference engine (9) wherein said aircraft intent (8) and said aircraft configuration (7) are obtained. Then the recorded flight data (4), the weather data (6) provided by the numerical prevision weather model together with the calculated aircraft intent (8) and the calculated aircraft configuration (7) are sent (15) to the trajectory computation infrastructure (3).

Independently from the origin of the recorded flight data (4), the degraded APM (2), the weather data (6), the aircraft intent (8) and a plurality of initial conditions are used for computing the trajectory data (10) of the aircraft by means of a trajectory computation infrastructure (3). Making use of the degraded APM (2), a new computation is launched in order to compare the computed trajectory data (10) with the recorded trajectory data (5). Then, the computed (**TRJ_{C}**) (10) and the recorded or real (**TRJ_{R}**) (5) trajectories are compared.

If the difference (11), in absolute values, of target state variables (basically fuel consumption or aircraft weight) between the nominal recorded trajectory data (5) and computed trajectory data (10) is negligible, an enhanced APM (12) is obtained. This difference is considered negligible when this difference is less than a predefined threshold (|**TRJ_{C}**-TRJ_{R}| < *ε*). If this difference is more than the predefined threshold (|TRJ_{C}-TRJ_{R}| > *ε*) an iterative process which implies a modification of the APDM is followed until such difference meets the defined threshold (*ε*). The enhanced APM (12) is the final instance of the APM, obtained after an iterative process, which best fits the performances of a real aircraft.

The process can be executed for each set of Recorded Flight Data available for the same aircraft. This process would ensure that the modeling of aircraft performance gather the most updated information about the considered aircraft. However, from ATM point of view, this is not the optimal use of the method. In this environment, it is more interesting to enhance the models used by ground-based automation tools providing with the APM which statistically best fits the performance of the aircraft of the same type and of the same airline. This will allow to "customize" the trajectory predictions of the aircraft of a specific company which are supposed to be subject to similar maintenance procedures.

If this process is used for a fleet of different aircraft of the same family (regardless the airline), the enhanced APM would represent the average performances of the considered fleet according to environment (aerodrome and standard ATC procedures) in which the predictions capabilities are required.

Therefore, the present solution takes advantage of an infrastructure capable of representing aircraft trajectories with high fidelity while introducing a process for improving the description of the aircraft performances required for increasing the accuracy of the trajectory computations.

The description of the different advantageous implementations has been presented for purposes of illustration and description, and is not intended to be exhaustive or limited to the implementations in the form disclosed. Many modifications and variations will be apparent to those of ordinary skill in the art. Further, different advantageous implementations may provide different advantages as compared to other advantageous implementations. The implementation or implementations selected are chosen and described in order to best explain the principles of the implementations, the practical application, and to enable others of ordinary skill in the art to understand the disclosure for various implementations with various modifications as are suited to the particular use contemplated. This written description uses examples to disclose various implementations, which include the best mode, to enable any person skilled in the art to practice those implementations, including making and using any devices or systems and performing any incorporated methods. The patentable scope is defined by the claims, and may include other examples that occur to those skilled in the art. Such other examples are intended to be within the scope of the claims if they have stages that do not differ from the literal language of the claims, or if they include equivalent stages with insubstantial differences from the literal languages of the claims.

## Claims

1. Computer implemented method for modeling aircraft performance through adaptive aircraft performance models using aircraft performance data; the aircraft performance data comprising recorded trajectory data of the aircraft, weather data faced during trajectory of the aircraft, aircraft configuration data and an aircraft intent **characterized in that** the method comprises the following stages:
a) introducing aircraft degradation coefficients in a nominal aircraft performance model of the aircraft, obtaining a degraded aircraft performance model;
b) calculating computed trajectory data in a trajectory computation infrastructure using as inputs the aircraft intent which represents the trajectory data, the weather data and the degraded aircraft performance model;
c) comparing the recorded trajectory data with the computed trajectory data;
d) obtaining an enhanced aircraft performance model by considering the degraded aircraft performance model as the enhanced aircraft performance model, when the result of the comparison is less than a previously established threshold; and
e) modifying, when the result of the comparison is higher than the previously established threshold, the aircraft degradation coefficients and executing steps a) to e) of the method, until the result of the comparison is less than the previously established threshold.

2. Computer implemented method for modeling aircraft performance through adaptive aircraft performance models using aircraft performance data, according to claim 1, **characterized in that** the aircraft degradation coefficients are modeled by worsening the coefficients which instantiate a polynomial description of the aircraft performance.

3. Computer implemented method for modeling aircraft performance through adaptive aircraft performance models using aircraft performance data, according to claim 1, **characterized in that** the coefficients which instantiate the polynomial description of the aircraft performance are selected among coefficients of drag polar, engine thrust and fuel consumption of the aircraft.

4. Computer implemented method for modeling aircraft performance through adaptive aircraft performance models using aircraft performance data, according to claim 1, **characterized in that** the aircraft intent and the aircraft configuration are obtained by aircraft intent inference techniques which use as inputs the weather data, the recorded trajectory data of the aircraft and the nominal aircraft performance model.

5. Computer implemented method for modeling aircraft performance through adaptive aircraft performance models using aircraft performance data, according to claim 1, **characterized in that** the comparing stage is carried out by comparing target state variables between the recorded trajectory data and the computed trajectory data.

6. Computer implemented method for modeling aircraft performance through adaptive aircraft performance models using aircraft performance data, according to claim 5, **characterized in that** the target state variables are selected among fuel consumption and net thrust.

## Patentansprüche

1. Computerimplementiertes Verfahren für die Modellierung einer Flugzeugleistung durch adaptive Flugzeugleistungsmodelle mit Hilfe von Flugzeugleistungsdaten; wobei die Flugzeugleistungsdaten aufgezeichnete Flugbahndaten des Flugzeuges, Wetterdaten, die während der Flugbahn des Flugzeuges angetroffen werden, Flugzeugkonfigurationsdaten und ein Flugzeugverhalten umfassen, **dadurch gekennzeichnet, dass** das Verfahren die folgenden Schritte umfasst:
a) Einführen von Flugzeug-Beeinträchtigungskoeffizienten in einem nominellen Flugzeugleistungsmodell des Flugzeugs, die ein beeinträchtigtes Flugzeugleistungsmodell liefern;
b) Kalkulieren errechneter Flugbahndaten in einer Flugbahnberechnungsinfrastruktur unter Verwendung des Flugzeugverhaltens, das die Flugbahndaten repräsentiert, der Wetterdaten und des beeinträchtigten Flugzeugleistungsmodells als Eingaben;
c) Vergleichen der aufgezeichneten Flugbahndaten mit den berechneten Flugbahndaten;
d) Beziehen eines verbesserten Flugzeugleistungsmodells durch Berücksichtigen des beeinträchtigten Flugzeugleistungsmodells als das verbesserte Flugzeugleistungsmodell, wenn das Ergebnis des Vergleiches kleiner ist als ein zuvor aufgestellter Schwellenwert; und
e) wenn das Ergebnis des Vergleichs größer ist als der zuvor aufgestellte Schwellenwert, Abändern der Flugzeug-Beeinträchtigungskoeffizienten und Ausführen der Schritte a) bis e) des Verfahrens, bis das Vergleichsergebnis geringer ist als der zuvor aufgestellte Schwellenwert.

2. Computerimplementiertes Verfahren für die Modellierung einer Flugzeugleistung durch adaptive Flugzeugleistungsmodelle mit Hilfe von Flugzeugleistungsdaten nach Anspruch 1, **dadurch gekennzeichnet, dass** die Flugzeug-Beeinträchtigungskoeffizienten durch Verschlechtern der Koeffizienten modelliert werden, die eine Polynombeschreibung der Flugzeugleistung instanziieren.

3. Computerimplementiertes Verfahren für die Modellierung einer Flugzeugleistung durch adaptive Flugzeugleistungsmodelle mit Hilfe von Flugzeugleistungsdaten nach Anspruch 1, **dadurch gekennzeichnet, dass** die Koeffizienten, die die Polynombeschreibung der Flugzeugleistung instanziieren, aus Koeffizienten von Drag Polar, Triebwerksschub und Brennstoffverbrauch des Flugzeugs gewählt werden.

4. Computerimplementiertes Verfahren für die Modellierung einer Flugzeugleistung durch adaptive Flugzeugleistungsmodelle mit Hilfe von Flugzeugleistungsdaten nach Anspruch 1, **dadurch gekennzeichnet, dass** das Flugzeugverhalten und die Flugzeugbeschaffenheit durch Flugzeugverhalten-Interferenztechniken bezogen werden, die als Eingaben die Wetterdaten, die aufgezeichneten Flugbahndaten des Flugzeugs und das nominelle Flugzeugleistungsmodell verwenden.

5. Computerimplementiertes Verfahren für die Modellierung einer Flugzeugleistung durch adaptive Flugzeugleistungsmodelle mit Hilfe von Flugzeugleistungsdaten nach Anspruch 1, **dadurch gekennzeichnet, dass** der Vergleichsschritt durch Vergleichen von Sollzustandsvariablen zwischen den aufgezeichneten Flugbahndaten und den berechneten Flugbahndaten ausgeführt wird.

6. Computerimplementiertes Verfahren für die Modellierung einer Flugzeugleistung durch adaptive Flugzeugleistungsmodelle mit Hilfe von Flugzeugleistungsdaten nach Anspruch 5, **dadurch gekennzeichnet, dass** die Sollzustandsvariablen aus Brennstoffverbrauch und Nettoschub gewählt werden.

## Revendications

1. Procédé mis en oeuvre par un ordinateur pour modéliser une performance d'avion par des modèles de performance d'avion adaptatifs en utilisant des données de performance d'avion ; les données de performance d'avion comprenant des données de trajectoire enregistrées de l'avion, des données météorologiques rencontrées pendant une trajectoire de l'avion, des données de configuration d'avion et une intention de l'avion, **caractérisé en ce que** le procédé comprend les étapes suivantes :
a) d'introduction de coefficients de dégradation d'avion dans un modèle de performance d'avion nominale de l'avion, obtenant un modèle de performance d'avion dégradé ;
b) de calcul de données de trajectoire calculées dans une infrastructure de calcul de trajectoire en utilisant, en tant qu'entrées, l'intention de l'avion qui représente les données de trajectoire, les données météorologiques et le modèle de performance d'avion dégradé ;
c) de comparaison des données de trajectoire enregistrées avec les données de trajectoire calculées ;
d) d'obtention d'un modèle de performance d'avion amélioré en prenant en considération le modèle de performance d'avion dégradé en tant que modèle de performance d'avion amélioré, lorsque le résultat de la comparaison est inférieur à un seuil établi précédemment ; et
e) de modification, lorsque le résultat de la comparaison est supérieur au seuil établi précédemment, des coefficients de dégradation d'avion, et d'exécution des étapes a) à e) du procédé, jusqu'à ce que le résultat de la comparaison soit inférieur au seuil établi précédemment.

2. Procédé mis en oeuvre par un ordinateur pour modéliser une performance d'avion par des modèles de performance d'avion adaptatifs en utilisant des données de performance d'avion, selon la revendication 1, **caractérisé en ce que** les coefficients de dégradation d'avion sont modélisés en détériorant les coefficients qui instancient une description polynomiale de la performance d'avion.

3. Procédé mis en oeuvre par un ordinateur pour modéliser une performance d'avion par des modèles de performance d'avion adaptatifs en utilisant des données de performance d'avion, selon la revendication 1, **caractérisé en ce que** les coefficients qui instancient la description polynomiale de la performance d'avion sont sélectionnés parmi les coefficients de la polaire de traînée, de la poussée de moteur et de la consommation de carburant de l'avion.

4. Procédé mis en oeuvre par un ordinateur pour modéliser une performance d'avion par des modèles de performance d'avion adaptatifs en utilisant des données de performance d'avion, selon la revendication 1, **caractérisé en ce que** l'intention de l'avion et la configuration de l'avion sont obtenues par des techniques de déduction d'intention d'avion qui utilisent, en tant qu'entrées, les données météorologiques, les données de trajectoire enregistrées de l'avion et le modèle de performance d'avion nominale.

5. Procédé mis en oeuvre par un ordinateur pour modéliser une performance d'avion par des modèles de performance d'avion adaptatifs en utilisant des données de performance d'avion, selon la revendication 1, **caractérisé en ce que** l'étape de comparaison est effectuée en comparant des variables d'état cibles entre les données de trajectoire enregistrées et les données de trajectoire calculées.

6. Procédé mis en oeuvre par un ordinateur pour modéliser une performance d'avion par des modèles de performance d'avion adaptatifs en utilisant des données de performance d'avion, selon la revendication 5, **caractérisé en ce que** les variables d'état cibles sont sélectionnées parmi une consommation de carburant et une poussée nette.
